# EUROPÄISCHE PATENTSCHRIFT

(11) **EP 2 422 009 B1**
(45) Veröffentlichungstag und Bekanntmachung des Hinweises auf die Patenterteilung: **03.04.2013**
(21) Anmeldenummer: 10714624.3
(22) Anmeldetag: 16.04.2010
(51) Int. Cl.: D06F 39/00, H03K 17/975

(54) **PROGRAMMWÄHLER FÜR EIN HAUSGERÄT, INSBESONDERE FÜR EINE WASCHMASCHINE, UND HAUSGERÄT MIT EINEM SOLCHEM PROGRAMMWÄHLER**
PROGRAM SELECTOR FOR A HOUSEHOLD APPLIANCE, IN PARTICULAR A WASHING MACHING, AND HOUSEHOLD APPLIANCE WITH SUCH A PROGRAM SELECTOR
SÉLECTEUR DE PROGRAMMES POUR APPAREIL ÉLECTROMÉNAGER, EN PARTICULIER UNE MACHINE À LAVER, ET APPAREIL ÉLECTROMÉNAGER DOTÉ D'UN TEL SÉLECTEUR DE PROGRAMMES

(30) Priorität: 24.04.2009 DE 102009002623
(43) Veröffentlichungstag der Anmeldung: 29.02.2012
(73) Patentinhaber: BSH Bosch und Siemens Hausgeräte GmbH, 81739 München (DE)
(72) Erfinder: PIEHLER, Thorsten, 93049 Regensburg (DE); PIERMEIER, Simon, 94379 Sankt Englmar (DE); REDELSTAB, Markus, 93059 Regensburg (DE); SCHIEDER, Josef, 93055 Regensburg (DE)
(86) Internationale Anmeldenummer: PCT/EP2010/055006
(87) Internationale Veröffentlichungsnummer: WO 2010/121949

(56) Entgegenhaltungen:
- EP-A2- 0 920 042
- GB-A- 2 050 621
- US-A- 4 233 593
- US-A1- 2008 111 428

## Beschreibung

Die Erfindung betrifft eine Bedieneinrichtung zur Auswahl einer Funktion aus einer Mehrzahl von Funktionen eines Hausgerätes, wie beispielsweise einer Waschmaschine, eines Wäschetrockners oder eines Waschtrockners. Die Erfindung bezieht sich des Weiteren auf ein Hausgerät mit einer derartigen Bedieneinrichtung.

Programmdrehwähler zur Auswahl von Funktionen einer Waschmaschine sind bereits aus dem Stand der Technik in vielfältiger Ausgestaltung bekannt. Die Druckschrift EP 1 527 519 B1 beschreibt einen Drehwähler aus dem Hause der Anmelderin, welche als Bedieneinrichtung zur Ein- und Ausschaltung und automatischen Steuerung einer Vielzahl unterschiedlicher Programmabläufe von elektrisch betriebenen Geräten, wie Waschmaschinen, Wäschetrocknern oder dergleichen, bereitgestellt ist. Der bekannte Drehwähler umfasst ein Bedienelement, das an einer Blende drehbar gelagert ist. Dabei ist das Bedienelement über eine mechanische Welle mit einem Drehfeldsensor verbunden.

Ein ähnlicher Drehwähler zur Auswahl von Funktionen eines Hausgerätes ist aus der Druckschrift DE 102 34 925 A1 bekannt.

Aus dem Stand der Technik sind des Weiteren kapazitive Berührungs- und Annäherungssensoren bekannt, die immer häufiger bei Hausgeräten zur Auswahl von Funktionen eingesetzt werden. Ein solcher kapazitiver Berührungs- und Annäherungssensor ist beispielsweise aus der Druckschrift DE 10 2005 041 113 A1 bekannt. Der bekannte Sensor weist eine Sensorelektrode auf, die als Teil eines Kondensators mit veränderlicher Kapazität bereitgestellt ist. Die Sensorelektrode ist dabei mit einer Auswerteschaltung verbunden. Wird ein Finger einer Bedienperson, der ein vom Potential der Sensorelektrode verschiedenes Potential, insbesondere Erdpotential, führt, an die Sensorelektrode angenähert, so wird dadurch eine Kapazitätsänderung eines die Sensorelektrode und den Finger aufweisenden Kondensators hervorgerufen. Diese Kapazitätsänderung wird dann durch die Auswerteschaltung erkannt.

Ein entsprechender Berührungs- und Annäherungssensor ist aus der Druckschrift US 2006/0145539 A1 bekannt. Bei diesem Sensor ist eine Sensorelektrode bereitgestellt, welche mit einer Auswerteschaltung elektrisch leitfähig gekoppelt ist. Am Ausgang dieser Auswerteschaltung ist ein Auswertesignal erzeugbar, dessen Frequenz in Abhängigkeit von der Kapazität eines die Sensorelektrode aufweisenden Kondensators veränderbar ist. Anhand der Frequenz kann somit festgestellt werden, ob sich ein Finger einer Bedienperson an die Sensorelektrode annähert. Es kann somit die Betätigung eines Bedienknopfes oder dergleichen auf kapazitivem Wege erkannt werden.

Ein kapazitiver Annäherungs- und Berührungssensor ist außerdem aus dem Dokument DE 102 50 395 A1 bekannt.

Zum einen ist an den bekannten Programmdrehwählern als nachteilig der Umstand anzusehen, dass sie mechanisch aufwendig ausgebildet sind. Ein herkömmlicher Programmdrehwähler bedarf nämlich einer mechanischen Verbindung zwischen einem an einer Bedienblende drehbar angeordneten Bedienelement und einer Auswerteschaltung, die hinter der Blende, also im Inneren des Hausgerätes, angeordnet ist. Um eine solche mechanische Verbindung zu gewährleisten, muss in der Bedienblende eine Durchgangsöffnung bereitgestellt werden, so dass Wasser und Schmutz in das Hausgeräteinnere eindringen können. Solche mechanischen Programmdrehwähler sind außerdem aufgrund der mechanischen Verbindung verschleißbehaftet.

Zum anderen sind die bekannten kapazitiven Bewegungs- und Annäherungssensoren zwar kostengünstiger und weniger verschleißbehaftet als die mechanischen Drehwähler, mit den bisher bekannten kapazitiven Sensoren kann jedoch die durch einen herkömmlichen Drehwähler etablierte Bedienphilosophie bzw. das Bedienkonzept nicht aufrechterhalten werden.

Die Druckschrift DE 10 2006 054 764 A1 beschreibt eine Bedienvorrichtung für ein Elektrokochfeld. Die Bedienvorrichtung beinhaltet ein Bedienelement, welches auf einer Auflage aufgesetzt ist. Selbiges Bedienelement weist an einer Oberseite sowie an einer Unterseite jeweils eine Vielzahl von elektrisch leitfähigen kreisringsegmentartigen Metallflächen auf. Die Metallflächen sind paarweise miteinander elektrisch verbunden:

Jeweils eine an der Oberseite angeordnete Metallfläche ist mit einer zugeordneten Metallfläche an der Unterseite verbunden. Auch unterhalb der Auflage befindet sich eine Vielzahl von elektrischen Elektroden, die mit einer Schaltungsanordnung gekoppelt sind. Das Auflegen eines Fingers auf eine der Metallflächen an der Oberseite wird direkt an eine entsprechende Metallfläche an der Unterseite gekoppelt und kann kapazitiv von einer Elektrode unterhalb der Auflage erfasst und von der Schaltungsanordnung ausgewertet werden.

Aus der Druckschrift DE 20 2005 019 978 U1 ist eine Bedienvorrichtung für ein Elektrogerät bekannt. Eine Bedieneinheit ist an einer Bedienblende bzw. Auflagefläche des Elektrogeräts drehbeweglich oder schiebebeweglich gelagert. Die Bedieneinheit beinhaltet einen Dreh- oder Schieberegler, auf welchem ein weiteres Schaltmittel angeordnet ist. Ein Steuergerät ist unterhalb der Auflagefläche angeordnet.

Die Druckschrift WO 2005/019766 A2 beschreibt eine Bedieneinrichtung für elektrische Geräte. Die Bedieneinrichtung umfasst einen resistiven Streifen, in welchen eine Vielzahl von elektrischen Anschlüssen integriert sind. Die elektrischen Anschlüsse sind mit einer elektronischen Schaltungsanordnung gekoppelt. Die Anschlüsse sind jeweils mit einem Erfassungskanal der Schaltungsanordnung verbunden. Die Schaltungsanordnung kann die Stelle an dem resistiven Streifen erkennen, die eine Bedienperson berührt.

Aus der Druckschrift WO 2007/014780 A1 ist ein Bedienelement bekannt, welches in Kraftfahrzeugen eingesetzt werden kann.

Die Druckschrift US 42 33 593 A offenbart ein Bedienelement, welches die Form eines Programmdrehwählers aufweist. Dieses Dokument wird als nächtliegender Stand der Technik angesehen.

Es ist Aufgabe der Erfindung, eine mechanisch robuste Bedieneinrichtung zur Auswahl unterschiedlicher Programmabläufe eines Hausgerätes bereitzustellen.

Diese Aufgabe wird erfindungsgemäß durch eine Bedieneinrichtung mit den Merkmalen nach Patentanspruch 1 sowie durch ein Hausgerät, welches die Merkmale nach Patentanspruch 9 aufweist, gelöst. Vorteilhafte Ausgestaltungen der Erfindung sind in den abhängigen Ansprüchen angegeben.

Eine erfindungsgemäße Bedieneinrichtung ist zur Auswahl einer Funktion aus einer Mehrzahl von Funktionen eines Hausgerätes ausgebildet. Die Bedieneinrichtung umfasst eine kapazitive Berührungs- oder Annäherungssensorvorrichtung, die eine Mehrzahl von elektrisch voneinander isolierten Sensorelektroden aufweist. Die Sensorelektroden sind mit einer, insbesondere gemeinsamen, Auswerteschaltung elektrisch gekoppelt. Die Sensorelektroden sind hinter einer Bedienblende des Hausgerätes angeordnet. Die Bedienblende besteht vorzugsweise aus elektrisch isolierendem Material. Die Sensorelektroden sind aus elektrisch leitfähigem Material, wie beispielsweise Kupfer, ausgebildet. An der Bedienblende ist ein Bedienelement bewegbar angeordnet, das einen Basiskörper und ein an einer der Bedienblende zugewandten Seite des Basiskörpers angebrachtes elektrisch leitfähiges Element aufweist. Das elektrisch leitfähige Element wirkt mit wenigstens einer der Sensorelektroden abhängig von der Stellung des Bedienelements beim Betätigen des Bedienelements durch eine Bedienperson kapazitiv zusammen.

Es wird somit erfindungsgemäß eine Bedieneinrichtung geschaffen, bei welcher einerseits das Bedienkonzept eines bewegbaren mechanischen Programmwählers aufrechterhalten und andererseits eine mechanische Entkopplung zwischen dem Bedienelement und der hausgeräteseitigen Auswerteschaltung gewährleistet wird. Aufgrund dieser mechanischen Entkopplung, d. h. insbesondere aufgrund des Verzichts auf eine mechanische Verbindung zwischen dem Bedienelement und der Auswerteschaltung mithilfe einer Welle - wie sie beispielsweise im Gegenstand gemäß Druckschrift EP 1 527 519 B1 eingesetzt wird - wird eine besonders verschleißarme Bedieneinrichtung geschaffen. Dies bewirkt ferner, dass keine Durchgangsöffnung in der Bedienblende erforderlich ist, welche im Stand der Technik zum Eindringen von Wasser oder Schmutz in das Hausgeräteinnere führt. Auf diesem Wege gelingt es ferner, die elektrische Betriebssicherheit des Hausgerätes im Vergleich zum Stand der Technik zu verbessern. Schließlich bietet der Einsatz der kapazitiven Berührungs- oder Annäherungssensorvorrichtung die Möglichkeit der innovativen Weiterentwicklung, beispielsweise hinsichtlich der Auswertung der Kapazitätsänderung der jeweils eine Sensorelektrode aufweisenden Kondensatoren.

Der Basiskörper des Bedienelements weist ein der Bedienblende zugewandtes und aus einem elektrisch isolierenden Material ausgebildetes erstes Zylinderteil auf. An eine von der Bedienblende abgewandte Seite dieses ersten Zylinderteils schließt sich unmittelbar ein vollständig aus einem elektrisch leitfähigen Material bereitgestelltes zweites Zylinderteil an. Dieses zweite Zylinderteil kann aus Metall, Aluminium oder auch aus einem leitfähigen Kunststoff oder dergleichen ausgebildet sein. Es kann alternativ auch lediglich eine elektrisch leitfähige Oberfläche aufweisen. Dies kann zum Beispiel durch einen leitfähigen Lack oder eine andere leitfähige Beschichtung erzielt werden. Das elektrisch leitfähige Element ist bei dieser Ausführungsform bevorzugt an einer der Bedienblende zugewandten Seite des ersten Zylinderteils angebracht und mit dem zweiten Zylinderteil elektrisch gekoppelt. Diese Merkmale bewirken, dass beim Betätigen des Bedienelements insgesamt zwei Kapazitäten - einerseits die Kapazität zwischen der Bedienperson und dem elektrisch leitfähigen zweiten Zylinderteil und andererseits die Kapazität zwischen dem elektrisch leitfähigen Element und den jeweiligen Sensorelektroden - erzeugt werden. Wird das Bedienelement durch eine Bedienperson, die ein vom Potential der Sensorelektroden verschiedenes Potential, insbesondere Erdpotential, führt, gedreht, so ändern sich die jeweiligen Kapazitäten derjenigen Kondensatoren, die einerseits das elektrisch leitfähige Element und andererseits die betroffenen Sensorelektroden aufweisen. Mit anderen Worten erlaubt das elektrisch leitfähige zweite Zylinderteil die Einkopplung der Personenkapazität der Bedienperson über die Sensorelektroden in die Auswerteschaltung.

Bei der Bedieneinrichtung wird eine durch die Bewegung des Bedienelements und somit des am Bedienelement angebrachten elektrisch leitfähigen Elements verursachte Beeinflussung des kapazitiven Nahfeldes über den an der Bedienblende angebrachten Sensorelektroden gemessen. Aufgrund dieser Beeinflussung wird dann eine absolute und/oder relative Position des Bedienelements durch die Auswerteschaltung bestimmt, so dass auf eine ausgewählte Funktion des Hausgerätes geschlossen werden kann.

Die Auswertung der jeweiligen kapazitiven Eigenschaften der Sensorelektroden kann beispielsweise, wie im Gegenstand gemäß Druckschrift DE 10 2005 041 113 A1 erfolgen. Danach kann die Auswerteschaltung für jede Sensorelektrode einen Transistor, wie z.B. einen PNP-Bipolartransistor, aufweisen, dessen Basis über einen Ohmschen Widerstand mit der Sensorelektrode verbunden ist. Mit dem Emitter des Transistors kann ein Ausgang eines Mikrokontrollers gekoppelt sein, an welchem ein Taktsignal vom Mikrokontroller abgegeben wird. Der Kollektor des Transistors kann mit einem Abtast-Halter-Glied (Sample and Hold) verbunden sein, durch welches ein Gleichspannungssignal an einen Eingang des Mikrokontrollers erzeugbar ist. Anhand des Gleichspannungssignals kann die Kapazitätsänderung des die Sensorelektrode umfassenden Kondensators erfasst und die Betätigung der Bedieneinrichtung erkannt werden. Die Änderung der jeweiligen Kapazitätseigenschaften kann somit anhand der Amplitude eines Gleichspannungssignals erkannt werden.

Alternativ kann die Auswerteschaltung derart ausgebildet sein, dass die Änderung der jeweiligen Kapazitätseigenschaften in Abhängigkeit von der Frequenz eines Wechselspannungssignals erkennbar ist.

Die Sensorelektroden sind bevorzugt direkt an einer Rückseite der Bedienblende angebracht. Dann kann der Abstand zwischen dem an dem Bedienelement angebrachten leitfähigen Element und den jeweiligen Elektroden auf ein Minimum reduziert werden, und die Kapazitäten der jeweiligen Sensorelektroden können auf ein Maximum eingestellt werden.

Es kann vorgesehen sein, dass die Elektrizitätskonstante εᵣ des Materials der Bedienblende an die vorliegende Anwendung, insbesondere an den Abstand zwischen dem Bedienelement und den Sensorelektroden - also an die Dicke der Bedienblende - und/oder an die Fläche einer einzelnen Sensorelektrode, angepasst wird. Dann können die Kapazitäten der Elektroden und somit auch die Einkopplung des elektrischen Feldes optimiert werden.

Die Sensorelektroden können an einer Folie - z.B. Kunststofffolie - angebracht sein, die an einer Rückseite der Bedienblende angeordnet ist. Bei dieser Ausführungsform können die Sensorelektroden durch eine leitfähige Beschichtung der Folie gebildet sein. Dies hat den Vorteil, dass die Sensorelektroden auch an einer gewölbten Oberfläche der Bedienblende angebracht, z.B. aufgeklebt, werden können.

Alternativ können die Sensorelektroden beabstandet zu der Rückseite der Bedienblende angeordnet sein, nämlich beispielsweise an einem Elektrodenträger angebracht sein. Ein solcher Elektrodenträger kann z.B. durch eine Leiterplatte (PCB) oder auch eine Flexleiterplatte (FPC) gebildet sein. Bei dieser Ausführungsform können zusätzlich Koppelelemente vorgesehen sein, die von einer jeden Sensorelektrode abstehen und in Richtung zur Bedienblende weisen; die Koppelelemente können die Rückseite der Bedienblende auch berühren. Dann wird der Abstand zwischen den Elektroden und der Rückseite der Bedienblende durch die Koppelelemente überbrückt, und das elektrische Fels kann von dem Bedienelement an die jeweiligen Sensorelektroden übertragen werden. Als Koppelelemente können beispielsweise elektrisch leitfähige Rahmenfedern vorgesehen sein.

Vorzugsweise ist das Bedienelement zylinderförmig ausgebildet und an der Bedienblende drehbar angeordnet. Somit wird eine besonders bequeme und benutzerfreundliche Bedieneinrichtung bereitgestellt, bei welcher das Bedienkonzept eines herkömmlichen Programmdrehwählers aufrechterhalten wird.

Die Sensorelektroden können in Umfangsrichtung eines Kreises verteilt angeordnet sein. Die Sensorelektroden können jeweils beispielsweise kreissektorförmig oder kreisringsektorförmig ausgebildet sein. Es kann auch vorgesehen sein, dass jeweils zwei benachbarte Sensorelektroden miteinander verzahnt sind. Alternativ kann der Übergang zwischen zwei benachbarten Sensorelektroden derart erfolgen, dass eine der Sensorelektroden eine keilförmige oder anders geartete Einbuchtung aufweist, in welche eine Ausprägung - z.B. ein keilförmiger Bereich oder ein Gewölbe - aufgenommen ist. Bei dieser Ausführungsform verläuft eine Drehachse des Bedienelements insbesondere durch einen Mittelpunkt eines durch die Sensorelektroden definierten Kreisringes oder Kreises. Dann ist gewährleistet, dass in jeder Winkelstellung des Bedienelements das elektrisch leitfähige Element mit wenigstens einer Sensorelektrode in kapazitiver Wirkverbindung, d.h. in Überlappung, angeordnet ist. Wird das Bedienelement aus einer ersten Winkelstellung in eine zweite Winkelstellung gedreht, so kann die Auswerteschaltung sowohl die absolute als auch relative Winkelstellung des Bedienelements anhand der relativen Bewegung des elektrisch leitfähigen Elements bezüglich der Sensorelektroden erkennen.

Der Basiskörper des Bedienelements ist bevorzugt mit einer Bedienkappe bzw. Hülse ummantelt und mit dieser bewegungsfest, insbesondere drehfest, verbunden. Dann stellt die Bedienkappe einen Teil des Bedienelements dar und ist gemeinsam mit dem Basiskörper sowie dem elektrisch leitfähigen Element an der Bedienblende bewegbar, insbesondere drehbar, angeordnet. Bei dieser Ausführungsform kann die Bedienkappe wie eine Kappe eines herkömmlichen Programmdrehwählers, insbesondere mit einem daran angebrachten Markierungspunkt oder einer Markierungslinie, ausgeführt sein.

Die Bedieneinrichtung kann auch als Annäherungs-Sensor verwendet werden. Dann ist die Auswerteschaltung dazu ausgebildet, eine Annäherung einer Bedienperson an das Bedienelement zu erkennen. Es kann zum Beispiel so aussehen, dass die Auswerteschaltung nach Erkennen einer Bedienperson das Hausgerät von einem Standby-Zustand in einen Aktivzustand überführt. Die Auswerteschaltung kann auch erkennen, in welcher (Winkel)-Stellung sich momentan das Bedienelement befindet und welche Funktion des Hausgerätes momentan angewählt ist. Somit können mehrere Funktionen in die Bedieneinrichtung integriert werden.

Zur Erfindung gehört auch ein Hausgerät, welches eine erfindungsgemäße Bedieneinrichtung umfasst. Unter einem Hausgerät wird hier allgemein ein Gerät verstanden, das zur Haushaltsführung eingesetzt wird. Das kann ein Haushaltsgroßgerät sein, wie beispielsweise eine Waschmaschine, ein Wäschetrockner, ein Waschtrockner, eine Geschirrspülmaschine, ein Gargerät, eine Dunstabzugshaube, ein Kältegerät oder ein Klimagerät. Das kann aber auch ein Haushaltskleingerät sein, wie beispielsweise ein Kaffeevollautomat, eine Küchenmaschine oder ein Staubsauger.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen, wobei die Erfindung durch die Ansprüche definiert ist.

Die Erfindung wird nun anhand eines einzelner bevorzugten Ausführungsbeispiels sowie anhand der beigefügten Zeichnungen näher erläutert. Dabei zeigen:
- Fig. 1: in schematischer und leicht perspektivischer Darstellung eine Rückseite einer Bedienblende mit daran angebrachten Sensorelektroden einer Bedieneinrichtung gemäß einer Ausführungsform der Erfindung;
- Fig. 2: eine schematische Draufsicht auf die Sensorelektroden;
- Fig. 3: in schematischer und perspektivischer Darstellung einen Basiskörper eines Bedienelements einschließlich eines am Basiskörper angeordneten elektrisch leitfähigen Elements für die Bedieneinrichtung; und
- Fig. 4: in schematischer und perspektivischer Darstellung das Bedienelement mit einer Bedienkappe, mit welcher der Basiskörper gemäß Fig. 3 ummantelt ist, wobei das Bedienelement an der Bedienblende drehbar angeordnet ist.

In den Figuren werden gleiche und funktionsgleiche Elemente mit den gleichen Bezugszeichen versehen.

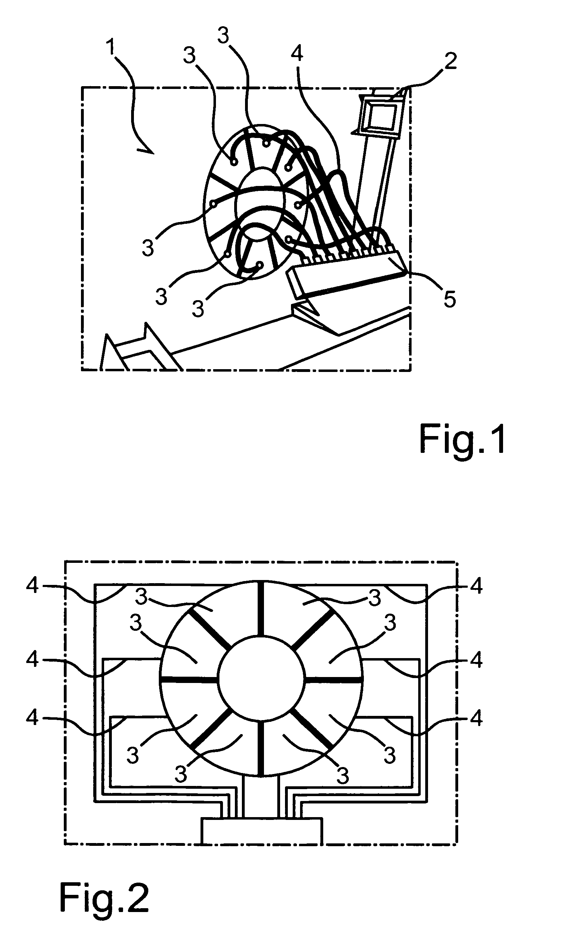

In Fig. 1 ist eine Innenwand bzw. Rückseite 1 einer Bedienblende 2 eines Hausgerätes, beispielsweise einer Waschmaschine, dargestellt. An der Rückseite 1 der Bedienblende 2 sind eine Mehrzahl von Sensorelektroden 3 angebracht. Die Sensorelektroden 3 sind durch ein elektrisch leitfähiges Material, wie beispielsweise Kupfer, bereitgestellt und jeweils in Form eines flachen bzw. planen Kreisringsektors ausgebildet. Die Sensorelektroden 3 bilden insgesamt eine Sensorelektrodenanordnung, die die Form eines Kreisringes aufweist, welcher durch eine Fläche zwischen einem äußeren und einem inneren Ring definiert ist. Die Sensorelektroden 3 sind dabei galvanisch voneinander getrennt bzw. voneinander elektrisch entkoppelt angeordnet. Die Sensorelektroden 3 sind über jeweils ein Koppelelement 4 - hier jeweils eine elektrische Leitung - sowie über eine gemeinsame Steckleiste 5 mit einer in den Figuren nicht dargestellten elektronischen Auswerteschaltung elektrisch verbunden. Als Koppelelemente 4 können auch Federn, Leitgummis u.ä. verwendet werden. Die Verbindung der Sensorelektroden 3 mit der Auswerteschaltung kann auch ohne die Steckleiste 5 auskommen; dann sind die Sensorelektroden 3 direkt mit der Auswerteschaltung gekoppelt. Gleichfalls können die Sensorelektroden 3 zur Rückseite 1 der Bedienblende 2 beabstandet angeordnet sein, nämlich insbesondere durch einen Elektrodenträger gehalten sein.

In Fig. 2 ist eine Draufsicht auf die Sensorelektroden 3 schematisch dargestellt. Man erkennt einen durch die Sensorelektroden 3 gebildeten Kreisring sowie die Kreisringsektor-Form der einzelnen Sensorelektroden 3.

Die Auswerteschaltung, mit der die Sensorelektroden 3 gekoppelt sind, ist dazu ausgebildet, die Kapazität zwischen jeweils einer Sensorelektrode 3 und dem elektrischen Erdpotential zu messen. Diese Kapazität wird beispielsweise durch die Annäherung eines metallischen oder nichtmetallischen Stoffes an eine aktive Zone der Sensorelektroden 3 beeinflusst. Dieses Phänomen wird hier zur Auswahl einer Funktion aus einer Mehrzahl von Funktionen bzw. Programmabläufen des Hausgerätes ausgenutzt. Dabei kann die Auswerteschaltung die ausgewählte Funktion anhand der Änderung der einzelnen Kapazitäten der Sensorelektroden 3 bezüglich des elektrischen Erdpotentials erkennen. Dies kann beispielsweise, wie im Gegenstand gemäß Druckschrift DE 10 2005 041 113 A1 und wie dazu in der Beschreibungseinleitung dargelegt, erfolgen.

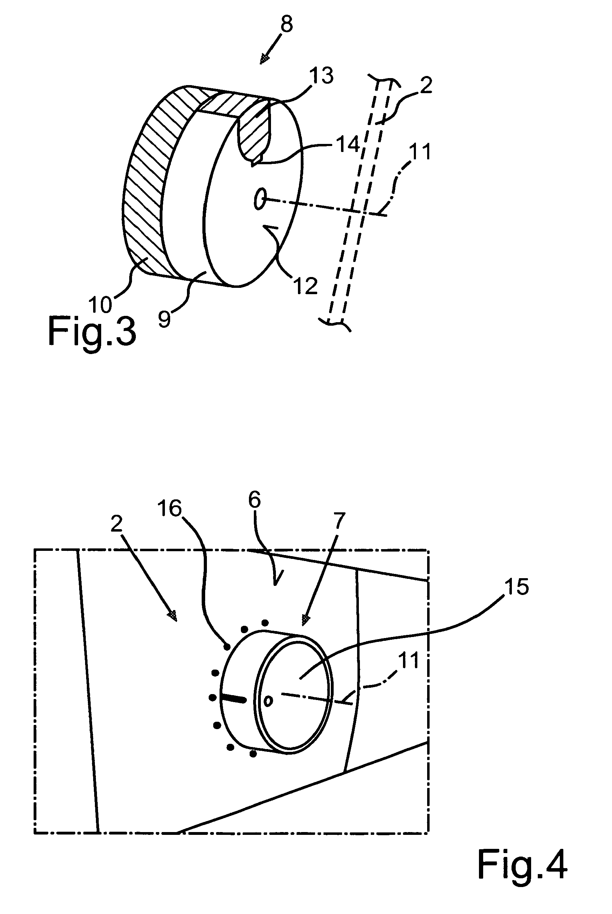

An einer den Sensorelektroden 3 gegenüber liegenden Frontseite 6 (siehe Fig. 4) der Bedienblende 2 ist ein Bedienelement 7 drehbar gelagert. Ein Basiskörper 8 des Bedienelements 7 ist in Fig. 3 schematisch abgebildet. Der Basiskörper 8 ist insgesamt zylinderförmig ausgeformt und weist ein erstes Zylinderteil 9 sowie ein zweites Zylinderteil 10 auf. Das erste Zylinderteil 9 ist aus einem elektrisch isolierenden Material bereitgestellt. Das zweite Zylinderteil 10 schließt sich an das erste Zylinderteil 9 unmittelbar an und ist im Beispiel vollständig aus einem elektrisch leitfähigen Material bereitgestellt, nämlich beispielsweise aus Metall, aus Aluminium o.ä. Der Basiskörper 8 weist eine Drehachse 11 auf, um welche das Bedienelement 7 an der Bedienblende 2 drehbar angeordnet ist (siehe Fig. 4). Mit dem Bezugszeichen 12 ist in Fig. 3 eine Seite des Basiskörpers 8 versehen, die der Bedienblende 2 und somit den Sensorelektroden 3 zugewandt ist. Die Bedienblende 2 ist in Fig. 3 schematisch angedeutet, um die Orientierung der Seite 12 des Basiskörpers 8 zur Bedienblende 2 zu verdeutlichen.

An dem Basiskörper 8 ist ein elektrisch leitfähiges Element 13 angebracht. Das Element 13 ist beispielsweise aus Kupfer oder aus einem anderen elektrisch leitfähigen Material bereitgestellt. Es ist in Form eines planen und geknickten bzw. eckigen Streifens ausgebildet. Das Element 13 ist mit dem zweiten Zylinderteil 10 elektrisch gekoppelt und erstreckt sich vom zweiten Zylinderteil 10 über ein Segment des Außenumfanges des ersten Zylinderteils 9 hin zu einem an der Seite 12 des Basiskörpers 8 angeordneten Punkt 14, welcher von der Drehachse 11 etwas beabstandet angeordnet ist. Der an der Seite 12 angebrachte Teil des leitfähigen Elements 13 weist insbesondere solche Abmessungen auf, dass er eine einzelne Sensorelektrode 3 möglichst komplett überdecken kann.

Wie bereits erwähnt, ist die Seite 12 des Basiskörpers 8 im montierten Zustand des Bedienelements 7 der Bedienblende 2 bzw. den Sensorelektroden 3 zugewandet. Dabei sind der Basiskörper 8 und die Sensorelektrodenanordnung 3 derart aufeinander abgestimmt, dass die Drehachse 11 des Basiskörpers 8 durch einen Mittelpunkt des durch die Sensorelektroden 3 gebildeten Kreisringes verläuft. Somit ist gewährleistet, dass das Element 13 in jeder Winkelstellung des Bedienelements 7 mit wenigstens einer Sensorelektrode 3 in Überlappung bzw. in kapazitiver Wirkverbindung angeordnet ist.

In Fig. 4 ist die Frontseite 6 der Bedienblende 2 mit dem Bedienelement 7 in schematischer und perspektivischer Darstellung abgebildet. Das Bedienelement 7 weist hier eine Bedienkappe bzw. -hülse 15 auf, die aus einem elektrisch isolierenden Material, beispielsweise aus Kunststoff, bereitgestellt ist. Die Bedienkappe 15 ist auf den Basiskörper 8 aufgeschoben, d. h. der Basiskörper 8 ist mittels der Bedienkappe 15 ummantelt. Mit anderen Worten ist die Bedienkappe 15 am Basiskörper 8 außenumfänglich angeordnet und deckt zusätzlich seine von der Bedienblende 2 abgewandte Stirnseite ab.

Berührt nun eine Bedienperson das Bedienelement 7 oder nähert sich die Bedienperson an dasselbe an, so ändern sich die elektrischen Kapazitäten der Sensorelektroden 3 in Bezug auf das Erdpotential. Dabei wird diejenige Sensorelektrode 3 am meisten beeinflusst, welcher das elektrisch leitfähige Element 13 zugewandt ist. Die Auswerteschaltung kann somit erkennen, in welcher Winkelstellung sich momentan das Bedienelement 7 befindet und welche Funktion des Hausgerätes momentan angewählt ist. Wird nun das Bedienelement 7 um die Drehachse 11 gedreht, so kann die Auswerteschaltung den zurückgelegten Winkelweg des Bedienelements 7 anhand der Kapazitätsänderungen erfassen. Die Auswerteschaltung kann darüber hinaus die Endstellung, in welche das Bedienelement 7 gedreht wird, erkennen, um die durch die Bedienperson ausgewählte Funktion zu erkennen.

Bezugnehmend weiterhin auf Fig. 4 sei erwähnt, dass an der Frontseite 6 der Bedienblende 2 eine optische Anzeigeeinrichtung angeordnet sein kann, mittels welcher der Bedienperson die jeweils gegenwärtig angewählte Funktion angezeigt wird. Diese Anzeigeeinrichtung kann Leuchtdioden 16 umfassen, die an der Frontseite 6 der Bedienblende 2 um das Bedienelement 7 herum angeordnet sind. Die Leuchtdioden 16, die beispielsweise als organische Leuchtdioden (OLED) oder herkömmliche LEDs bereitgestellt werden können, sind dann in einem gleichen Abstand zur Drehachse 11 des Bedienelements 7 an der Bedienblende 2 angeordnet. Die Anordnung der Leuchtdioden 16 sowie deren relative Positionierung zueinander können jedoch beliebig sein. Zum Beispiel können die Leuchtdioden 16 insgesamt in der Form eines Balkens an der Bedienblende 2 angeordnet sein. Dabei ist eine horizontale, eine vertikale, wie auch eine schräge Anordnung möglich. Die Leuchtdioden 16 können aber auch einzeln an der Bedienblende 2 verteilt angeordnet sein. Wird durch die Bedienperson eine Funktion des Hausgerätes angewählt, so beginnt eine dieser Funktion zugeordnete und diese Funktion signalisierende Leuchtdiode 16 zu leuchten. Diese Leuchtdiode 16 wird ausgeschaltet, sobald eine andere Funktion des Hausgerätes angewählt und eine benachbarte Leuchtdiode 16 eingeschaltet wird, indem das Bedienelement 7 um eine Winkelstellung gedreht wird. Ergänzend oder alternativ kann die gewählte Funktion auch an einem Display angezeigt werden.

Insgesamt wird gemäß dem Beispiel ein Bedienelement 7 geschaffen, welches die Form eines herkömmlichen Programmdrehwählers aufweist, das jedoch keine mechanische Verbindung zum Hausgeräteinneren aufweist und somit besonders verschleißarm ausgeführt ist. Beim Aufrechterhalten des Bedienkonzeptes eines herkömmlichen Programmdrehwählers werden somit die Robustheit und die elektrische Betriebssicherheit der Bedieneinrichtung erhöht.

### Bezugszeichenliste

- 1: Rückseite
- 2: Bedienblende
- 3: Sensorelektroden
- 4: elektrische Leitungen
- 5: Steckleiste
- 6: Frontseite
- 7: Bedienelement
- 8: Basiskörper
- 9, 10: Zylinderteile
- 11: Drehachse
- 12: Seite des Basiskörpers
- 13: elektrisch leitfähiges Element
- 14: Punkt
- 15: Bedienkappe
- 16: Leuchtdioden

## Patentansprüche

1. Bedieneinrichtung zur Auswahl einer Funktion aus einer Mehrzahl von Funktionen eines Hausgerätes, mit einer kapazitiven Berührungs- oder Annäherungssensorvorrichtung, die eine Mehrzahl von elektrisch voneinander isolierten Sensorelektroden (3) aufweist, die mit einer Auswerteschaltung elektrisch gekoppelt sind, wobei die Sensorelektroden (3) hinter einer Bedienblende (2) des Hausgerätes angeordnet sind und ein Bedienelement (7) an der Bedienblende (2) bewegbar angeordnet ist, das einen Basiskörper (8) und ein an einer der Bedienblende (2) zugewandten Seite (12) des Basiskörpers (8) angebrachtes elektrisch leitfähiges Element (13) aufweist, das abhängig von der Stellung des Bedienelements (7) mit wenigstens einer der Sensorelektroden (3) beim Betätigen des Bedienelements (7) durch eine Bedienperson kapazitiv zusammenwirkt, **dadurch gekennzeichnet, dass** der Basiskörper (8) ein der Bedienblende (2) zugewandtes und aus einem elektrisch isolierenden Material ausgebildetes erstes Zylinderteil (9) sowie ein sich an eine von der Bedienblende (2) abgewandte Seite des ersten Zylinderteils (9) unmittelbar anschließendes, vollständig aus einem elektrisch leitfähigen Material ausgebildetes zweites Zylinderteil (10) aufweist, wobei das am ersten Zylinderteil (9) angebrachte elektrisch leitfähige Element (13) mit dem zweiten Zylinderteil (10) elektrisch gekoppelt ist.

2. Bedieneinrichtung nach Anspruch 1, **dadurch gekennzeichnet, dass** die Sensorelektroden (3) direkt an einer Rückseite (1) der Bedienblende (2) angeordnet sind.

3. Bedieneinrichtung nach Anspruch 1 oder 2, **dadurch gekennzeichnet, dass** die Sensorelektroden (3) an einer Folie angeordnet sind, welche an einer Rückseite (1) der Bedienblende (2) angebracht ist, wobei bevorzugt die Sensorelektroden (3) durch eine leitfähige Beschichtung der Folie gebildet sind.

4. Bedieneinrichtung nach Anspruch 1, **dadurch gekennzeichnet, dass** die Sensorelektroden (3) an einem Elektrodenträger angebracht sind, welcher zu einer Rückseite (1) der Bedienblende (2) beabstandet angeordnet ist.

5. Bedieneinrichtung nach einem der vorhergehenden Ansprüche, **dadurch gekennzeichnet, dass** das Bedienelement (7) zylinderförmig ausgebildet und an der Bedienblende (2) drehbar angeordnet ist.

6. Bedieneinrichtung nach einem der vorhergehenden Ansprüche, **dadurch gekennzeichnet, dass** die Sensorelektroden (3) in Umfangsrichtung eines Kreises verteilt angeordnet sind, insbesondere jeweils kreissektorförmig oder kreisringsektorförmig ausgebildet sind.

7. Bedieneinrichtung nach einem der vorhergehenden Ansprüche, **dadurch gekennzeichnet, dass** der Basiskörper (8) mit einer Bedienkappe (15) ummantelt und mit dieser bewegungsfest, insbesondere drehfest, verbunden ist.

8. Bedieneinrichtung nach einem der vorhergehenden Ansprüche, **dadurch gekennzeichnet, dass** die Auswerteschaltung dazu ausgebildet ist, durch Auswertung der jeweiligen Kapazitäten der Sensorelektroden eine Annäherung einer Bedienperson an das Bedienelement zu erkennen.

9. Hausgerät mit einer Bedieneinrichtung nach einem der vorhergehenden Ansprüche.

## Claims

1. Control device for selecting a function from a plurality of functions of a domestic appliance, with a capacitive touch or proximity sensor device having a plurality of mutually electrically insulated sensor electrodes (3), which are electrically coupled with an evaluating circuit, wherein the sensor electrodes (3) are arranged behind a control panel (2) of the domestic appliance and a control element (7) is arranged at the control panel (2) to be movable, which control element comprises a base body (8) and an electrically conductive element (13), which is mounted at a side (12) of the base body (8) facing the control panel (2) and which independently of the setting of the control element (7) capacitively co-operates with at least one of the sensor electrodes (3) when the control element (7) is actuated by a user, **characterised in that** the base body (8) comprises a first cylinder part (9), which faces the control panel (2) and is constructed from an electrically insulating material, as well as a second cylinder part (10), which directly adjoins a side of the first cylinder part (9) remote from the control panel (2) and which is constructed entirely from an electrically conductive material, wherein the electrically conductive element (13) mounted at the first cylinder part (9) is electrically coupled with the second cylinder part (10).

2. Control device according to claim 1, **characterised in that** the sensor electrodes (3) are arranged directly at a rear side (1) of the control panel (2).

3. Control device according to claim 1 or 2, **characterised in that** the sensor electrodes (3) are arranged at a foil mounted on a rear side (1) of the control panel (2), wherein the sensor electrodes (3) are preferably formed by a conductive coating of the foil.

4. Control device according to claim 1, **characterised in that** the sensor electrodes (3) are mounted on an electrode support which is arranged at a spacing from a rear side (1) of the control panel (2).

5. Control device according to any one of the preceding claims, **characterised in that** the control element (7) is of cylindrical construction and rotatably arranged at the control panel (3).

6. Control device according to any one of the preceding claims, **characterised in that** the sensor electrodes (3) are arranged in distribution in the circumferential direction of a circle, particularly are each constructed to have the shape of a sector of a circle or the shape of a sector of an annulus.

7. Control device according to any one of the preceding claims, **characterised in that** the base body (8) is encased by a control cap (15) and connected therewith to be secure against movement, in particular rotation, relative thereto.

8. Control device according to any one of the preceding claims, **characterised in that** the evaluating circuit is constructed for the purpose of recognising, by evaluation of the respective capacitances of the sensor electrodes, an approach of a user to the control element.

9. Domestic appliance with a control device according to any one of the preceding claims.

## Revendications

1. Dispositif de commande pour la sélection d'une fonction parmi une pluralité de fonctions d'un appareil électroménager, comprenant un dispositif capacitif de contact ou de capteurs de proximité qui présente une pluralité d'électrodes de capteur (3) électriquement isolées les unes des autres, lesquelles sont couplées électriquement à un circuit d'évaluation, les électrodes de capteur (3) étant disposées derrière un bandeau de commande (2) de l'appareil électroménager et un élément de commande (7) étant disposé de manière déplaçable sur le bandeau de commande (2), lequel élément de commande présente un corps de base (8) et un élément électro-conducteur (13) placé sur un côté du corps de base (8) tourné vers le bandeau de commande (2), lequel élément électro-conducteur, en fonction de la position de l'élément de commande (7), coopère capacitivement avec au moins une des électrodes de capteur (3) lors de l'activation de l'élément de commande (7) par une personne de commande, **caractérisé en ce que** le corps de base (8) présente une première partie de cylindre (9) tournée vers le bandeau de commande (2), réalisée dans une matière électriquement isolante, ainsi qu'une deuxième partie de cylindre (10) se raccordant directement à un côté de la première partie de cylindre (9), détourné du bandeau de commande (2), réalisée complètement dans une matière électro-conductrice, l'élément électro-conducteur (13) placé sur la première partie de cylindre (9) étant couplé électriquement à la deuxième partie de cylindre (10).

2. Dispositif de commande selon la revendication 1, **caractérisé en ce que** les électrodes de capteur (3) sont directement disposées sur une face arrière (1) du bandeau de commande (2).

3. Dispositif de commande selon la revendication 1 ou 2, **caractérisé en ce que** les électrodes de capteur (3) sont disposées sur une feuille placée sur une face arrière (1) du bandeau de commande (2), les électrodes de capteur (3) étant de préférence formées par un revêtement conducteur de la feuille.

4. Dispositif de commande selon la revendication 1, **caractérisé en ce que** les électrodes de capteur (3) sont placées sur un porte-électrodes qui est disposé avec écart par rapport à une face arrière (1) du bandeau de commande (2).

5. Dispositif de commande selon l'une quelconque des revendications précédentes, **caractérisé en ce que** l'élément de commande (7) est réalisé en forme de cylindre et est disposé de manière rotative sur le bandeau de commande (2).

6. Dispositif de commande selon l'une quelconque des revendications précédentes, **caractérisé en ce que** les électrodes de capteur (3) sont disposées en étant réparties dans le sens circonférentiel d'un cercle, notamment en étant respectivement réalisées en forme de secteur de cercle ou d'anneau de cercle.

7. Dispositif de commande selon l'une quelconque des revendications précédentes, **caractérisé en ce que** le corps de base (8) est entouré d'un capuchon de commande (15) et est raccordé à celui-ci de manière résistante aux mouvements, notamment de manière résistante à la torsion.

8. Dispositif de commande selon l'une quelconque des revendications précédentes, **caractérisé en ce que** le circuit d'évaluation est réalisé pour identifier une approche d'une personne de commande près de l'élément de commande par évaluation des capacités respectives des électrodes de capteur.

9. Appareil électroménager comprenant un dispositif de commande selon l'une quelconque des revendications précédentes.
